# EUROPÄISCHE PATENTSCHRIFT

(11) **EP 3 798 658 B1**
(45) Veröffentlichungstag und Bekanntmachung des Hinweises auf die Patenterteilung: **19.06.2024**
(21) Anmeldenummer: 19200342.4
(22) Anmeldetag: 30.09.2019
(51) Int. Cl.: G01R 33/483, G01R 33/561, G01R 33/567

(54) **VERBESSERTE SIMULTANE MEHRSCHICHT(SMS)-AUFNAHME VON MESSDATEN MITTELS MAGNETRESONANZTECHNIK**
IMPROVED SIMULTANEOUS MULTISLICE (SMS) ACQUISITION OF MEASUREMENT DATA BY MEANS OF MAGNETIC RESONANCE TECHNOLOGY
ENREGISTREMENT AMÉLIORÉ MULTICOUCHE SIMULTANÉ (SMS) DES DONNÉES DE MESURE AU MOYEN DE LA TECHNIQUE DU RÉSONANCE MAGNÉTIQUE

(43) Veröffentlichungstag der Anmeldung: 31.03.2021
(73) Patentinhaber: Siemens Healthineers AG, 91301 Forchheim (DE)
(72) Erfinder: Zeller, Mario, 91054 Erlangen (DE)
(74) Vertreter: Siemens Healthineers Patent Attorneys

(56) Entgegenhaltungen:
- EP-A1- 3 333 584
- DE-A1-102013 219 034
- DE-A1-102015 222 835
- MARKUS BARTH ET AL: "Simultaneous multislice (SMS) imaging techniques : SMS Imaging", MAGNETIC RESONANCE IN MEDICINE., Bd. 75, Nr. 1, 26. August 2015 (2015-08-26), Seiten 63-81, XP055408927, US ISSN: 0740-3194, DOI: 10.1002/mrm.25897

## Beschreibung

Die Erfindung betrifft eine verbesserte simultane Mehrschicht-Aufnahme von Messdaten mittels Magnetresonanztechnik.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einem Magnetresonanzgerät in einem vergleichsweise starken statischen, homogenen Grundmagnetfeld, auch B₀-Feld genannt, mit Feldstärken von 0,2 Tesla bis 7 Tesla und mehr positioniert, so dass sich dessen Kernspins entlang des Grundmagnetfeldes orientieren. Zum Auslösen von Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld schnell geschaltete magnetische Gradientenfelder, kurz Gradienten genannt, überlagert. Ein verwendetes Schema, das eine zeitliche Abfolge von einzustrahlenden RF-Pulsen und zu schaltenden Gradienten beschreibt, wird als Pulssequenz(schema), kurz auch als "Sequenz", bezeichnet. Die aufgezeichneten Messdaten werden digitalisiert und als komplexe Zahlenwerte in einer k-Raum-Matrix abgelegt. Aus der mit Werten belegten k-Raum-Matrix ist z.B. mittels einer mehrdimensionalen Fourier-Transformation ein zugehöriges MR-Bild rekonstruierbar. Die RF-Pulse werden mittels eines RF-Verstärkers (RFPA, englisch: "Radio Frequency Power Amplifier") erzeugt. In welchen Teilen des Untersuchungsobjekts die resonante Anregung der Kernspins erfolgt ist dabei abhängig von der effektiven lokalen Stärke des Magnetfeldes und der Frequenz der RF-Pulse, da die Resonanzfrequenz der Kernspins ihrerseits abhängig ist von der lokalen Magnetfeldstärke.

Durch entsprechende Variation kann also gezielt eine selektive Anregung einer bestimmten Schicht des Untersuchungsobjekts erfolgen.

Sogenannte parallele Akquisitionstechniken (ppa), wie z.B. GRAPPA ("GeneRalized Autocalibrating Partially Parallel Acquisition") oder SENSE ("Sensitivity Encoding"), bei denen mit Hilfe von mehreren RF-Spulen nur eine gemäß dem Nyquist-Theorem im k-Raum unterabgetastete Anzahl an Messdaten aufgenommen werden, werden eingesetzt, um z.B. die für die Aufnahme der Messdaten insgesamt nötige Messzeit zu verkürzen oder die Auflösung zu erhöhen. Die "fehlenden", d.h. nicht gemessenen aber für einen gemäß Nyquist vollständigen Satz an Messdaten erforderlichen, Messdaten werden hierbei auf Basis von Sensitivitätsdaten der verwendeten RF-Spulen und Kalibrierungsdaten und den gemessenen Messdaten ergänzt.

Der Wunsch nach immer schnelleren MR-Aufnahmen im klinischen Umfeld führte zu einer Renaissance von Verfahren, bei denen mehrere Bilder simultan aufgenommen werden. Allgemein lassen sich diese Verfahren dadurch charakterisieren, dass zumindest während eines Teils der Messung gezielt Transversalmagnetisierung von zumindest zwei Schichten gleichzeitig für den Bildgebungsprozess genutzt wird ("Multi-Schicht-Bildgebung"; "Schicht-Multiplexing"; "simultane Mehrschicht [Bildgebung]", engl. "Simultaneous Multi-Slice" (SMS)). Im Gegensatz dazu wird bei der etablierten "Mehrschicht-Bildgebung" das Signal von zumindest zwei Schichten alternierend, d. h. vollständig unabhängig voneinander mit entsprechender längerer Messzeit aufgenommen.

Bekannte SMS-Verfahren sind beispielsweise Verfahren, die Verfahren aus der oben genannten Bildgebung mittels ppa, bei welchen Wissen über die Sensitivitätsverteilung der bei dem Erfassen der Messdaten eingesetzten Empfangsspulen als zusätzliche Information genutzt wird, um gemäß Nyquist unterabgetastete Messdaten aufzufüllen, in Schicht-Richtung einsetzen, um überlagert aus mehreren Schichten aufgenommene Signale in Signale der einzelnen Schichten zu separieren. Zu diesen Verfahren gehören beispielsweise auch die CAIPIRINHA-Technik, wie sie von Breuer et al. in "Controlled Aliasing in Parallel Imaging Results in Hiher Acceleration (CAIPIRINHA) for Multi-Slice Imaging", Magnetic Resonance in Medicine 53, 2005, S. 684-691 beschrieben ist, und die blipped CAIPIRINHA-Technik, wie sie von Setsompop et al. in "Blipped-Controlled Aliasing in Parallel Imaging for Simultaneous Multislice Echo Planar Imaging With Reduced g-Factor Penalty", Magnetic Resonance in Medicine 67, 2012, S. 1210-1224, beschrieben wird, wobei der im letztgenannten Titel genannte g-Faktor ("gfactor", kurz für "Geometrie-Faktor") ein Maß für eine Trennbarkeit der verschiedenen verwendeten Empfangsspulen darstellt.

Mittlerweile sind SMS-Techniken für die MR-Bildgebung in Kombination mit einer Vielzahl an gängigen Pulssequenztypen, z.B. echoplanare SMS Bildgebung mit BOLD-Kontrast (engl. "echo-planar imaging with blood oxygenation level dependent contrast"; SMS EPI BOLD), echoplanare SMS Diffusionsbildgebung (engl. "echo-planar diffusion weighted imaging"; SMS EPI Diffusion, SMS EPI DWI), auch mit RESOLVE ("readout-segmented echo-planar imaging"), Turbo-Spin-Echo SMS (SMS TSE), auch in Verbindung mit Dixon-Techniken (z.B. SMS TSE Dixon).

Durch die gleichzeitige Aufnahme mehrerer Schichten kann in der Regel die Repetitionszeit TR und damit die Gesamtaufnahmezeit verringert werden. Die Repetitionszeit TR ist hierbei die für die Aufnahme aller Messdaten aus einem gewünschten Schichtstapel benötigte Messzeit, z.B. jeweils nach einer Präparation des gesamten Schichtstapels oder für zeitaufgelöste Bildserien, oder auch für eine einmalige Aufnahme der Messdaten des gewünschten Schichtstapels. Da in vielen Fällen ein gewisser Bildkontrast nur erzielt werden kann, wenn die Repetitionszeit TR ausreichend hoch gewählt wird, z.B. um eine ausreichende Relaxation einer Magnetisierung vor einer erneuten Anregung von Spins in dem Schichtstapel zu erlauben, ist eine tatsächlich durch einen Einsatz von SMS-Techniken erzielbare Messzeitreduktion oftmals nicht direkt proportional zu der Anzahl an gleichzeitig aufgenommenen Schichten, die auch als SMS-Faktor bezeichnet wird. In der EP3333584A1 wird ein entsprechendes SMS-Verfahren beschrieben. Die DE102013219034A1 beschreibt ein Verfahren zur Minimierung einer Repetitionszeit einer Magnetresonanzmessung.

Um gleichzeitig aufgenommene Messdaten mehrerer Schichten in Messdaten der einzelnen Schichten trennen zu können, muss die Sensitivitätsverteilung der bei dem Erfassen der Messdaten eingesetzten Empfangsspulen eine ausreichende Variation aufweisen, um die Messdaten der einzelnen Schichten unterscheidbar zu machen. Daher ist die Bildqualität bei mittels SMS-Techniken erstellten MR-Bildern höher, je größer die Variation in der Sensitivitätsverteilung der bei dem Erfassen der Messdaten eingesetzten Empfangsspulen ist. Daher ist es sinnvoll die Schichten, aus denen gleichzeitig Messdaten aufgenommen werden sollen, möglichst weit voneinander entfernt zu wählen. Daher sind SMS-Techniken bei MR-Bildgebungsprotokollen mit insgesamt nur wenigen Schichten und damit Schichtstapeln von nur wenigen Zentimetern, z.B. unter 4 Zentimeter, oder mit einer nur geringen Schichtabdeckung durch Schichtdicken von unter 5 Millimetern, wie z.B. bei einer Prostata-, Wirbelsäulen- oder Orbits-Bildgebung bisher nur eingeschränkt nutzbar.

Der Erfindung liegt die Aufgabe zugrunde, eine verbesserte simultane Mehrschicht(SMS)-Aufnahme von Messdaten mittels Magnetresonanztechnik zu ermöglichen, die es insbesondere erlaubt SMS-Aufnahmen auch für Anwendungen, in welchen dünne Schichten und/oder insgesamt nur gering ausgedehnte Schichtstapel abzubilden sind, wie z.B. bei MR-Prostatabildgebung, MR-Wirbelsäulenbildgebung oder auch MR-Orbitalbildgebung, nutzbar zu machen.

Die Aufgabe wird gelöst durch ein Verfahren zur Aufnahme von Messdaten eines Untersuchungsobjektes mittels Magnetresonanztechnik gemäß Anspruch 1, eine Magnetresonanzanlage gemäß Anspruch 11, ein Computerprogramm gemäß Anspruch 12, sowie einen elektronisch lesbaren Datenträger gemäß Anspruch 13.

Ein erfindungsgemäßes Verfahren zur verbesserten Aufnahme von Messdaten eines Untersuchungsobjektes mittels einer Magnetresonanzanlage mit Hilfe von einem simultanen Mehrschicht(SMS)-Verfahren unter Verwendung von mindestens zwei Empfangsspulen, bei dem Magnetresonanz(MR)-Signale in mindestens zwei Schichtgruppen aus unterschiedlichen Schichten des Untersuchungsobjekts aufgenommen werden, wobei von einer Schichtgruppe umfasste Schichten gleichzeitig bei einer Aufnahme von MR-Signalen aufgenommen werden, umfasst die Schritte:
- Laden eines Messprotokolls, mit welchem die MR-Signale aufgenommen werden sollen, welches einen aufzunehmenden Schichtstapel, einen bei der Aufnahme zu verwendenden SMS-Faktor F und zumindest ein Qualitätskriterium umfasst,
- Bestimmen einer minimalen Repetitionszeit TR in Abhängigkeit von dem zumindest einen Qualitätskriterium,
- Berechnen einer Anzahl K an Schichten aus denen mit einer auf Basis einer durch das Messprotokoll vorgegebenen Schichtgruppenmesszeit zur Anregung und Aufnahme von MR-Signalen einer Schichtgruppe und der bestimmten minimalen Repetitionszeit TR bestimmten Anzahl M an möglichen Anregungen und Aufnahmen von MR-Signalen einer Schichtgruppe innerhalb der bestimmten minimalen Repetitionszeit MR-Signale aufgenommen werden können,
- Bestimmen von Multi-Band-RF-Pulsen zur Anregung von M jeweils F Schichten umfassenden Schichtgruppen, die insgesamt den aufzunehmenden Schichtstapel umfassen,
- Aufnehmen von MR-Signalen unter Verwendung der Multi-Band-RF-Pulse innerhalb der bestimmten minimalen Repetitionszeit,
- Laden von Schichttrennungskalibrierungsdaten für den aufzunehmenden Schichtstapel,
- Trennen der MR-Signale der Schichtgruppen jeweils in Einzelschicht-MR-Signale der einzelnen von den Schichtgruppen umfassten Schichten unter Verwendung der Schichttrennungskalibrierungsdaten,
- Erstellen von Bilddaten mindestens einer von dem aufzunehmenden Schichtstapel umfassten Schicht durch Rekonstruktion der Einzelschicht-MR-Signale der Schicht, wobei auf Basis der bestimmten Anzahl K und auf Basis des Messprotokolls eine Anzahl von überzähligen Schichten und deren jeweilige Schichtposition bestimmt wird, und
wobei bei der Bestimmung der Multi-Band-RF-Pulse (MB₁...MB_{M}) für überzählige Schichten ein reduzierter Flipwinkel von ca. 33% eines entsprechenden, für nicht-überzählige Schichten vorgegebenen nicht-reduzierten Wertes eines anzuwendenden Flipwinkels oder weniger, vorgegeben wird.

Das Qualitätskriterium verlängert hierbei die durch die Verwendung eines SMS-Verfahrens eigentlich stark verkürzte Messzeit für die MR-Signale des aufzunehmenden Schichtstapels auf die minimale Repetitionszeit TR. Die somit erhaltene "Zeitreserve" (Differenz der bestimmten minimalen Repetitionszeit TR zu der rein mittels SMS-Verfahren benötigten Messzeit für den aufzunehmenden Schichtstapel) wird erfindungsgemäß ausgenutzt, um weitere Schichten bei der Aufnahme der MR-Signale zu berücksichtigen. Durch die Berücksichtigung weiterer

Schichten können einerseits weitere Informationen gewonnen werden, die z.B. für Korrekturverfahren verwendet werden können. Andererseits erhöht die Berücksichtigung weiterer Schichten die Bildqualität der erhaltenen Bilddaten, denn sie ermöglicht es den Abstand von Schichten, aus welchen gleichzeitig MR-Signale aufgenommen werden, zu erhöhen. Damit erhöht sich auch die Variation in dem Sensitivitätsverlauf der verwendeten Empfangsspulen, wodurch die überlagert aus mehreren Schichten aufgenommenen MR-Signale besser wieder getrennt werden können.

Das Verfahren findet insbesondere für Messprotokolle Anwendung, bei welchen die aufzunehmenden Schichten eine Schichtdicke von unter 3 Millimeter, bevorzugt unter 2 Millimeter, besonders bevorzugt etwa 1 Millimeter und/oder der zu messende Schichtstapel eine Dicke von unter 4 Zentimeter, bevorzugt unter 3 Zentimeter, besonders bevorzugt unter 2 Zentimeter haben. Bei derartig dünnen Schichten und Schichtstapeln mit einer derartig geringen Dicke (Ausdehnung in Schichtrichtung) ist es besonders vorteilhaft, wenn durch das erfindungsgemäße Verfahren ein Abstand von gleichzeitig aufzunehmenden Schichten vergrößert werden kann, und somit eine Distanz zwischen gleichzeitig aufzunehmenden Schichten vergrößert werden kann. In manchen Fällen, kann erst durch ein erfindungsgemäßes Verfahren der Abstand von gleichzeitig aufzunehmenden Schichten groß genug gewählt werden (z.B. über das Qualitätskriterium), um über eine Sensitivitätsverteilung der bei der Aufnahme der Messdaten verwendeten Empfangsspulen eine ausreichende Variation in den gleichzeitig aufgenommenen Messdaten zu erzeugen, die es erlaubt, die für die mehreren Schichten aufgenommenen Messdaten derart in Einzelschicht-Messdaten zu trennen, dass aus den Einzelschicht-Messdaten Bilddaten der einzelnen Schichten mit einer akzeptablen, z.B. für eine Diagnose ausreichenden, Bildqualität erstellt werden können.

Eine erfindungsgemäße Magnetresonanzanlage umfasst eine Magneteinheit, eine Gradienteneinheit, eine Hochfrequenzeinheit und eine zur Durchführung eines erfindungsgemäßen Verfahrens ausgebildete Steuereinrichtung mit einer Wiederholzeitbestimmungseinheit.

Ein erfindungsgemäßes Computerprogramm implementiert ein erfindungsgemäßes Verfahren auf einer Steuereinrichtung einer Magnetresonanzanlage, wenn es auf der Steuereinrichtung ausgeführt wird.

Das Computerprogramm kann hierbei auch in Form eines Computerprogrammprodukts vorliegen, welches direkt in einen Speicher einer Steuereinrichtung einer Magnetresonanzanlage ladbar ist, mit Programmcode-Mitteln, um ein erfindungsgemäßes Verfahren auszuführen, wenn das Computerprogrammprodukt in der Steuereinrichtung ausgeführt wird.

Ein erfindungsgemäßer elektronisch lesbarer Datenträger umfasst darauf gespeicherte elektronisch lesbare Steuerinformationen, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren angegebenen Vorteile und Ausführungen gelten analog auch für die Magnetresonanzanlage, das Computerprogrammprodukt und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:
- Fig. 1: ein schematisches Ablaufdiagramm eines erfindungsgemäßen Verfahrens,
- Fig. 2: ein beispielhaftes Zeitschema,
- Fig. 3: eine beispielhafte Darstellung eines in fünf Schichtgruppen aufgeteilten Schichtstapels,
- Fig. 4: eine beispielhafte Darstellung eines in acht Schichtgruppen aufgeteilten Schichtstapels,
- Fig. 5: eine schematisch dargestellte erfindungsgemäße Magnetresonanzanlage.

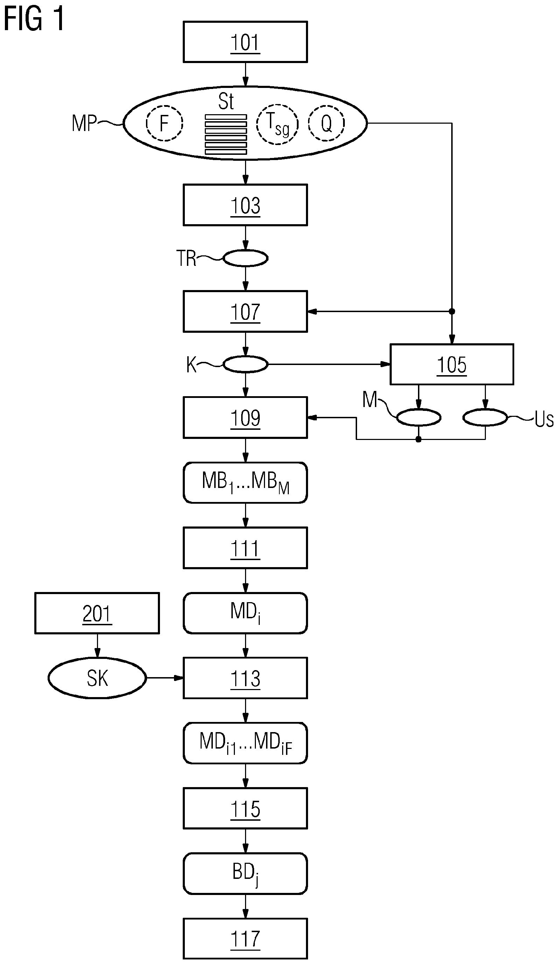

Figur 1 ist ein schematisches Ablaufdiagramm eines erfindungsgemäßen Verfahrens zur verbesserten Aufnahme von Messdaten eines Untersuchungsobjektes mittels einer Magnetresonanzanlage mit Hilfe von einem simultanen Mehrschicht(SMS)-Verfahren unter Verwendung von mindestens zwei Empfangsspulen, bei dem Magnetresonanz(MR)-Signale in mindestens zwei Schichtgruppen aus unterschiedlichen Schichten des Untersuchungsobjekts aufgenommen werden, wobei von einer Schichtgruppe umfasste Schichten gleichzeitig bei einer Aufnahme von MR-Signalen MDᵢ aufgenommen werden.

Dabei wird zunächst ein Messprotokoll MP geladen (Block 101). Das Messprotokoll umfasst Informationen über einen aufzunehmenden Schichtstapel St, einen bei der Aufnahme zu verwendenden SMS-Faktor F und zumindest ein Qualitätskriterium Q. Mit dem Schichtstapel St ist auch die Anzahl N der Schichten aus welchen (mindestens) MR-Signale aufgenommen werden sollen, deren Schichtdicke d und deren Position in dem Untersuchungsobjekt festgelegt.

In Abhängigkeit von dem zumindest einen Qualitätskriterium wird eine minimale Repetitionszeit TR bestimmt (Block 103), innerhalb derer alle für eine Erzeugung von Bilddaten aller Schichten des Schichtstapels St nötigen MR-Signale gemessen werden sollen.

Ein Qualitätskriterium kann hierbei ein gewünschter Kontrast sein, z.B. auch im Rahmen einer Diffusionsbildgebung oder einer Bildgebung mit BOLD-Kontrast, bei welchen z.B. wiederholt MR-Signale der Schichten des Schichtstapels nach jeweils einer anderen Kontrastpräparation durchgeführt werden. Soll ein gemäß der T1-, der T2- oder der T2*-Zerfallskonstanten des jeweils abgebildeten Gewebes gewichteter Kontrast erreicht werden, muss die Repetitionszeit TR ausreichend sein, um die gewünschten Zerfallsvorgänge abbilden zu können, da ansonsten der gewünschte Bildkontrast nicht in ausreichender Qualität aus den Messdaten ermittelbar ist. Die minimale Wiederholzeit TR kann für somit gleichzeitig die minimale Zeit angeben, die zwischen zwei aufeinanderfolgenden Aufnahmen von MR-Signalen der Schichten des Schichtstapels St verstreichen soll, bevor , ggf. nach einer geänderten Präparation, erneut MR-Signale der Schichten des Schichtstapels St aufgenommen werden, um das Qualitätskriterium zu erfüllen.

Zusätzlich oder alternativ kann ein Qualitätskriterium eine gewünschte Bildqualität sein. Diese kann, insbesondere in Abhängigkeit einer Sensitivitätsverteilung der für die Aufnahme der MR-Signale der Schichten des Schichtstapels St verwendeten Empfangsspulen, einen Mindestabstand A' festlegen, den Schichten einer Schichtgruppe, aus denen MR-Signale gleichzeitig aufgenommen werden, voneinander haben sollen. Mit anderen Worten kann durch das Qualitätskriterium ein Mindestabstand A' festgelegt sein, der bestimmt, welchen Abstand die Schichten eines Schichtstapels voneinander mindestens aufweisen müssen, um das Qualitätskriterium zu erfüllen. Durch einen derartigen Mindestabstand A` wird die Spulensensitivitätsvariation in Schichtrichtung erhöht, und damit die (diagnostische) Bildqualität für das verwendete SMS-Verfahren verbessert.

Auf Basis einer durch das Messprotokoll vorgegebenen Schichtgruppenmesszeit T_{sg} zur Anregung und Aufnahme von MR-Signalen einer Schichtgruppe, d.h. der Zeitdauer, die von der Anregung einer Schichtgruppe bis zum Abschluss der Aufnahme ihrer MR-Signale verstreicht, und der bestimmten minimalen Repetitionszeit, wird eine Anzahl M an möglichen Anregungen und Aufnahmen von MR-Signalen einer Schichtgruppe innerhalb der bestimmten minimalen Repetitionszeit TR bestimmt (Block 105), z.B. indem die minimale Repetitionszeit TR durch die Schichtgruppenmesszeit T_{sg} geteilt wird und ggf. auf eine natürliche Zahl abgerundet wird. Soll in dem Schichtstapel vor der Aufnahme der MR-Signale eine Präparation der Spins erfolgen, so ist die für die Präparation nötige Präparationszeitdauer TP zunächst von der minimalen Repetitionszeit TR abzuziehen, bevor das Ergebnis dieser Subtraktion durch die Schichtgruppenmesszeit T_{sg} geteilt wird und ggf. auf eine natürliche Zahl abgerundet wird.

Aus der so erhaltenen Anzahl M an möglichen Anregungen und Aufnahmen von MR-Signalen einer Schichtgruppe, kann durch Multiplikation der Anzahl M mit dem SMS-Faktor F eine Anzahl K an Schichten berechnet werden (Block 107), aus denen innerhalb der bestimmten minimalen Repetitionszeit TR mittels des Messprotokolls MR-Signale aufgenommen werden können. Die Anzahl K ist hierbei größer als die Anzahl der von dem aufzunehmenden Schichtstapel umfassten Schichten. Somit werden weitere Schichten berücksichtigt.

Durch Subtraktion der Anzahl der durch den aufzunehmenden Schichtstapel St vorgegebenen Anzahl an Schichten des Schichtstapels St von der Anzahl K an Schichten, aus denen innerhalb der bestimmten minimalen Repetitionszeit TR mittels des Messprotokolls MR-Signale aufgenommen werden können, kann eine Anzahl Us an "überzähligen" Schichten bestimmt werden, aus denen zwar innerhalb der minimalen Repetitionszeit unter Einhaltung des mindestens einen Qualitätskriteriums MR-Signale aufgenommen werden können, die aber nicht von dem Schichtstapel St umfasst sind (Block 105). Die überzähligen Schichten können z.B. über- und/oder unterhalb der von dem Schichtstapel St abgedeckten Positionen angeordnet werden. Die genaue Wahl der Anordnung der überzähligen Schichten kann z.B. auf Basis des Messprotokolls und z.B. der Position des Schichtstapels innerhalb des Untersuchungsobjekts, getroffen werden. Somit kann auf Basis der bestimmten Anzahl K und auf Basis des Messprotokolls eine Anzahl Us von überzähligen Schichten und deren jeweilige und Schichtposition bestimmt werden.

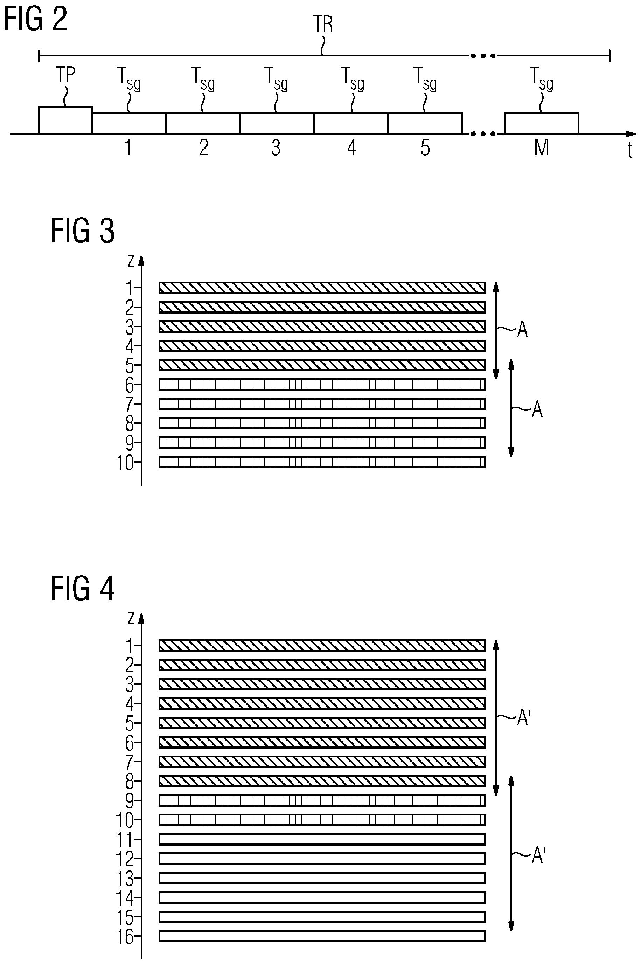

Figur 2 zeigt beispielhaft ein Zeitschema, das den zeitlichen Zusammenhang einer minimalen Repetitionszeit TR mit der Schichtgruppenmesszeit T_{sg} veranschaulicht. In die minimale Repetitionszeit TR passen in dem gezeigten Beispiel, nach einer (optionalen) Präparationszeitdauer TP, z.B. für eine Diffusionspräparation mit einem gewünschten Diffusionswert, M Schichtgruppenmesszeiten T_{sg}, wobei in jeder Schichtgruppenmesszeit T_{sg} eine andere von M jeweils F Schichten umfassenden Schichtgruppen angeregt und die erzeugten MR-Signale aufgenommen werden, sodass insgesamt M*F=K Schichten angeregt und deren MR-Signale aufgenommen werden.

In den Figuren 3 und 4 sind hierzu beispielhafte Darstellungen von Schichtstapeln, die in unterschiedlichen Repetitionszeiten TR aufgenommen werden, gezeigt.

Der in Figur 3 gezeigte Schichtstapel besteht aus zehn Schichten, die in fünf Schichtgruppen zu je zwei Schichten aufgenommen werden sollen. Die Schichten sind beispielhaft in z-Richtung benachbart angeordnet. Die Schichtgruppen umfassen jeweils eine Schicht aus einem ersten, hier schräg schraffiert dargestellten Positionsbereich (Schicht eins bis Schicht 5), und eine aus einem zweiten, längs schraffiert dargestellten Positionsbereich (Schicht sechs bis Schicht zehn). Der Abstand A zwischen den zwei Schichten jeder Schichtgruppe ist für die erste und die letzte Schichtgruppe durch je einen Doppelpfeil gekennzeichnet.

Für die Aufnahme der MR-Signale des dargestellten Schichtstapels muss somit eine Messzeit von fünf mal der Schichtgruppenmesszeit T_{sg}, ggf. plus eine Präparationszeitdauer TP, aufgewandt werden.

Ergibt eine erfindungsgemäße Berechnung einer minimalen Repetitionszeit TR, dass (um ein Qualitätskriterium zu erfüllen) eine längere Zeitdauer für die Aufnahme der MR-Signale der 10 Schichten des Schichtstapels zur Verfügung steht, z.B. drei weitere Schichtgruppenmesszeiten T_{sg}, kann der aufzunehmende Schichtstapel aus Figur 3 auch wie in der Figur 4 dargestellt vermessen werden.

Durch die im vorgestellten Beispiel drei weiteren zur Verfügung stehenden Schichtgruppenmesszeit T_{sg} können nicht nur fünf, sondern (M=)acht Schichtgruppen (zu je zwei Schichten) innerhalb der minimalen Repetitionszeit TR aufgenommen werden. Dies ist in Figur 4 dargestellt. Die acht Schichtgruppen umfassen hier jeweils eine Schicht aus einem ersten, hier schräg schraffiert dargestellten Positionsbereich (Schicht eins bis Schicht 8), und eine aus einem zweiten, längs schraffiert bzw. leer dargestellten Positionsbereich (Schicht neun bis Schicht 16).Durch die Aufnahme von acht Schichtgruppen anstelle von nur fünf, ist der Abstand A` (wieder für die erste und die letzte Schichtgruppe durch Doppelpfeile gekennzeichnet), der zwischen den jeweils zwei Schichten jeder Schichtgruppe der Figur 4 liegt, gegenüber der Anordnung in Figur 3 erhöht.

Es werden jedoch nicht nur die von dem aufzunehmenden Schichtstapel umfassten zehn Schichten, sondern insgesamt (K=)16 Schichten durch die acht Schichtgruppen aufgenommen. Die (Us=16-10=)sechs überzähligen Schichten (leer dargestellt, Schichten elf bis 16) wurden in dem Beispiel von Figur 4 unterhalb der Position des Schichtstapels (Schichten eins bis zehn) angeordnet.

Entsprechend der Anzahl M an möglichen Anregungen und Aufnahmen von MR-Signalen einer Schichtgruppe werden M Multi-Band-RF-Pulse (MB₁...MB_{M}) bestimmt, die gemäß dem SMS Faktor F jeweils F Schichten anregen, und die somit insgesamt K Schichten anregen, derart, dass der aufzunehmende Schichtstapel von den K Schichten umfasst ist (Block 109).

Ein Multi-Band-RF-Puls wird hierbei z.B. auf übliche Weise aus den für die einzelnen Schichten einer Schichtgruppe wirkenden RF-Pulsen zusammengesetzt. Je nach Art des, durch das Messprotokoll vorgegebenen, verwendeten Pulssequenztyps werden hierbei für RF-Pulse, die eine Anregung der Spins in einer Schicht bewirken sollen, üblicherweise Flipwinkel für die RF-Pulse von ca. 90° vorgegeben, und für RF-Pulse, die eine Refokussierung der Spins in einer Schicht bewirken sollen, üblicherweise Flipwinkel für die RF-Pulse von ca. 180° vorgegeben (z.B. im Rahmen von TSE-Sequenzen.

Hierbei kann bei der Bestimmung der Multi-Band-RF-Pulse MB₁...MB_{M} für einen auf eine der überzähligen Schichten wirkenden RF-Puls ein Flipwinkel von Null vorgegeben werden. Dadurch wird vermieden, dass durch die Berücksichtigung von überzähligen Schichten die spezifische Absorptionsrate (SAR) erhöht wird.

Erfindungsgemäß wird bei der Bestimmung der Multi-Band-RF-Pulse MB₁...MB_{M} für überzählige Schichten ein reduzierter Flipwinkel von ca. 33% eines entsprechenden, für nicht-überzählige Schichten vorgegebenen nicht-reduzierten Wertes eines anzuwendenden Flipwinkels oder weniger, beispielsweise ein reduzierter Flipwinkel von ca. 11% eines entsprechenden, für nicht-überzählige Schichten vorgegebenen nicht-reduzierten Wertes eines anzuwendenden Flipwinkels, bevorzugt von ca. 5°, vorgegeben. Dadurch wird trotz der Berücksichtigung von überzähligen Schichten die spezifische Absorptionsrate (SAR) nur gering erhöht. Darüber hinaus können so aus den überzähligen Schichten wegen des reduzierten Flipwinkels mit geringerer Signalstärke aufgenommene MR-Signale weitere Informationen gewonnen werden, z.B. können diese als Navigatordaten genutzt werden. Wie stark ein für überzählige Schichten vorgegebener reduzierter Flipwinkel reduziert wird, z.B. um welchen Faktor ein reduzierter Flipwinkel gegenüber einem entsprechenden, für nicht-überzählige Schichten vorgegebenen nicht-reduzierten Wertes eines anzuwendenden Flipwinkels reduziert ist, kann unter Abwägen von einer gewünschten SAR-Belastung durch die RF-Pulse mit reduziertem Flipwinkel und einer gewünschten Signalstärke der unter Verwendung der reduzierten Flipwinkel erzeugten Messdaten erfolgen.

Unter Verwendung der erzeugten Multi-Band-RF-Pulse MBᵢ können MR-Signale MDᵢ innerhalb der bestimmten minimalen Repetitionszeit aufgenommen werden (Block 111). Schichttrennungskalibrierungsdaten SK zumindest für den aufzunehmenden Schichtstapel und ggf. für alle K aufgenommenen Schichten werden geladen (Block 113). Die Schichttrennungskalibrierungsdaten SK können von einem Speicher abgerufen werden, oder zeitnah zu der Aufnahme der MR-Signale in Block 111 gemessen werden (Block 201).

Wurde bei der Bestimmung der Multi-Band-RF-Pulse MB₁...MB_{M} für einen auf eine der überzähligen Schichten wirkenden RF-Puls ein Flipwinkel von Null vorgegeben, können die Schichttrennungskalibrierungsdaten SK für derartige überzählige Schichten mit dem Wert Null oder mit Rauschen simulierenden Werten belegt werden. Die Schichttrennungskalibrierungsdaten SK für derartige überzählige Schichten müssen somit in diesem Fall nicht gemessen oder bestimmt werden, sondern können, ohne dass eine Aufnahme von Referenzdaten erfolgt, generiert werden.

Wurde bei der Bestimmung der Multi-Band-RF-Pulse MB₁...MB_{M} für überzählige Schichten ein reduzierter Flipwinkel vorgegeben (was erfindungsgemäß immer erfolgt), können die Schichttrennungskalibrierungsdaten SK für derartige überzählige Schichten mit demselben reduzierten Flipwinkel bestimmt werden, z.B. indem Referenzdaten, aus welchen die Schichttrennungskalibrierungsdaten SK bestimmt werden können, auch mit dem reduzierten Flipwinkel aufgenommen werden.

Es ist auch denkbar, bereits für überzählige Schichten (jedoch mit nicht-reduziertem Flipwinkel) bestimmte Schichttrennungskalibrierungsdaten SK durch Multiplikation mit einem Faktor zwischen Null und Eins in ihrer Amplitude zu reduzieren, um sie für die mit reduzierten Flipwinkel aufgenommenen überzähligen Schichten anzupassen. Dabei kann der Faktor von dem reduzierten Flipwinkel abhängen, insbesondere von dem Faktor, um den der reduzierte Flipwinkel gegenüber einem nicht-reduzierten Flipwinkel reduziert wurde.

Die aufgenommenen MR-Signale MDᵢ können für jede Schichtgruppe i (i=1...M) jeweils in Einzelschicht-MR-Signale MDᵢ₁ bis MD_{iF} der einzelnen, von den Schichtgruppen umfassten Schichten unter Verwendung der Schichttrennungskalibrierungsdaten SK getrennt werden (Block 113). Dies kann auf eine für SMS-Techniken übliche Art und Weise erfolgen.

Es können aus überzähligen Schichten aufgenommene MR-Signale verworfen werden. Dadurch kann Rechenleistung und Speicherplatz gespart werden.

Es ist jedoch auch denkbar, die aus überzähligen Schichten aufgenommenen MR-Signale als Navigatordaten zu verwenden, z.B. um Daten für eine Bewegungskorrektur zu erhalten.

Durch Rekonstruktion der Einzelschicht-MR-Signale MDᵢ₁ bis MD_{iF} können Bilddaten BDⱼ (mit 1≤j≤K-Us) mindestens einer der K-Us von dem Schichtstapel St umfassten Schichten erstellt werden (Block 115). Hierbei kann ebenfalls auf eine bei SMS-Techniken übliche Art und Weise erfolgen. Insbesondere können für alle in dem aufzunehmenden Schichtstapel St umfassten Schichten Bilddaten BDⱼ erstellt werden.

Erstellte Bilddaten BDj, aufgenommene MR-Signale MDᵢ und/oder getrennte Einzelschicht-MR-Signale MDᵢ₁ bis MD_{iF} können, z.B. für eine spätere Verwendung, gespeichert und/oder auf einem Anzeigegerät, z.B. für einen Nutzer, angezeigt werden.

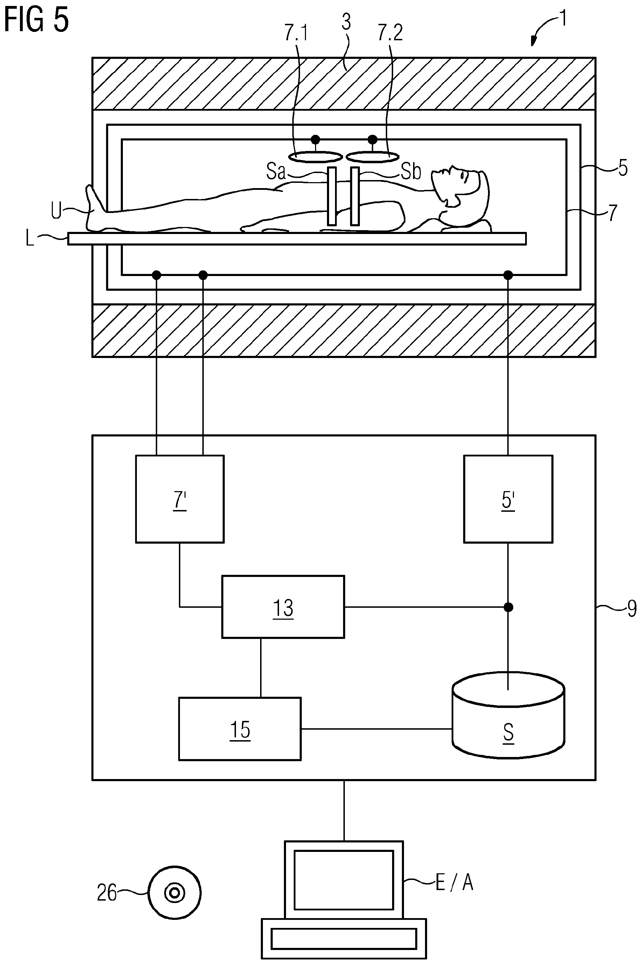

Figur 5 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9.

In der Figur 5 sind diese Teileinheiten der Magnetresonanzanlage 1 nur grob schematisch dargestellt. Insbesondere kann die Hochfrequenzeinheit 7 aus mehreren Untereinheiten, beispielsweise aus mehreren Spulen wie den schematisch gezeigten Spulen 7.1 und 7.2 oder mehr Spulen bestehen, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden. Die Schichten Sa und Sb stellen exemplarisch zwei unterschiedliche Schichten Sa und Sb des Untersuchungsobjekts dar, die einer Schichtgruppe angehören, und die bei einer Aufnahme von MR-Signalen gleichzeitig aufgenommen werden können.

Die Steuereinrichtung 9 dient der Steuerung der Magnetresonanzanlage 1 und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Bereich (beispielsweise in zu messenden Schichten S) des Untersuchungsobjekts U zuständig. Dabei wird die Mittenfrequenz des, auch als B1-Feld bezeichneten, Hochfrequenz-Wechselfeldes in aller Regel möglichst so eingestellt, dass sie nahe der Resonanzfrequenz der zu manipulierenden Spins liegt. Abweichungen der Mittenfrequenz von der Resonanzfrequenz werden als Off-Resonanz bezeichnet. Zur Erzeugung des B1-Feldes werden in der Hochfrequenzeinheit 7 mittels der Hochfrequenz-Sende-/Empfangs-Steuerung 7' gesteuerte Ströme an den HF-Spulen angelegt.

Weiterhin umfasst die Steuereinrichtung 9 eine Wiederholzeitbestimmungseinheit 15 mit welcher erfindungsgemäß Wiederholzeiten TR und damit eine Anzahl an möglichen Anregungen und Aufnahmen von Messdaten pro Wiederholzeit TR bestimmt werden können, die durch die Hochfrequenz-Sende-/Empfangs-Steuerung 7' umgesetzt werden können. Die Steuereinrichtung 9 ist insgesamt dazu ausgebildet, ein erfindungsgemäßes Verfahren durchzuführen.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogrammprodukts vorliegen, welches ein Programm umfasst und das beschriebene Verfahren auf einer Steuereinrichtung 9 der Magnetresonanzanlage implementiert, wenn es auf der Steuereinrichtung 9 ausgeführt wird. Ebenso kann ein elektronisch lesbarer Datenträger 26 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 26 in einer Steuereinrichtung 9 einer Magnetresonanzanlage 1 das beschriebene Verfahren durchführen.

## Patentansprüche

1. Verfahren zur verbesserten Aufnahme von Messdaten eines Untersuchungsobjektes mittels einer Magnetresonanzanlage mit Hilfe von einem simultanen Mehrschicht(SMS)-Verfahren unter Verwendung von mindestens zwei Empfangsspulen, bei dem Magnetresonanz(MR)-Signale in mindestens zwei Schichtgruppen aus unterschiedlichen Schichten des Untersuchungsobjekts (U) aufgenommen werden, wobei von einer Schichtgruppe umfasste Schichten gleichzeitig bei einer Aufnahme von MR-Signalen (MDᵢ) aufgenommen werden, umfassend die Schritte:
- Laden eines Messprotokolls, mit welchem die MR-Signale aufgenommen werden sollen, welches einen aufzunehmenden Schichtstapel, einen bei der Aufnahme zu verwendenden SMS-Faktor F und zumindest ein Qualitätskriterium umfasst,
- Bestimmen einer minimalen Repetitionszeit TR in Abhängigkeit von dem zumindest einen Qualitätskriterium,
- Berechnen einer Anzahl K an Schichten aus denen mit einer auf Basis einer durch das Messprotokoll vorgegebenen Schichtgruppenmesszeit zur Anregung und Aufnahme von MR-Signalen einer Schichtgruppe und der bestimmten minimalen Repetitionszeit TR bestimmten Anzahl M an möglichen Anregungen und Aufnahmen von MR-Signalen einer Schichtgruppe innerhalb der bestimmten minimalen Repetitionszeit MR-Signale aufgenommen werden können,
- Bestimmen von Multi-Band-RF-Pulsen (MB₁...MB_{M}) zur Anregung von M jeweils F Schichten umfassenden Schichtgruppen, die insgesamt den aufzunehmenden Schichtstapel umfassen,
- Aufnehmen von MR-Signalen (MDᵢ) unter Verwendung der Multi-Band-RF-Pulse (MBᵢ) innerhalb der bestimmten minimalen Repetitionszeit,
- Laden von Schichttrennungskalibrierungsdaten für den aufzunehmenden Schichtstapel,
- Trennen der MR-Signale (MDᵢ) der Schichtgruppen jeweils in Einzelschicht-MR-Signale (MDᵢ₁ ... MD_{iF}) der einzelnen von den Schichtgruppen umfassten Schichten unter Verwendung der Schichttrennungskalibrierungsdaten,
- Erstellen von Bilddaten (BDᵢⱼ) mindestens einer von dem aufzunehmenden Schichtstapel umfassten Schicht durch Rekonstruktion der Einzelschicht-MR-Signale (MDᵢ₁ ... MDᵢₖ) der Schicht,
wobei auf Basis der bestimmten Anzahl K und auf Basis des Messprotokolls eine Anzahl von überzähligen Schichten und deren jeweilige Schichtposition bestimmt wird, und
wobei bei der Bestimmung der Multi-Band-RF-Pulse (MB₁...MB_{M}) für überzählige Schichten ein reduzierter Flipwinkel von ca. 33% eines entsprechenden, für nicht-überzählige Schichten vorgegebenen nicht-reduzierten Wertes eines anzuwendenden Flipwinkels oder weniger, vorgegeben wird.

2. Verfahren nach Anspruch 1, wobei das zumindest eine Qualitätskriterium ein gewünschter Kontrast und/oder eine gewünschte Bildqualität ist.

3. Verfahren nach Anspruch 1 oder 2, wobei aus überzähligen Schichten aufgenommene MR-Signale verworfen werden.

4. Verfahren nach einem der vorhergehenden Ansprüche, wobei bei der Bestimmung der Multi-Band-RF-Pulse (MB₁...MB_{M}) für überzählige Schichten ein Flipwinkel von Null vorgegeben wird.

5. Verfahren nach Anspruch 4, wobei die Schichttrennungskalibrierungsdaten für überzählige Schichten mit dem Wert Null oder mit Rauschen simulierenden Werten belegt werden.

6. Verfahren nach einem der vorhergehenden Ansprüche, wobei Schichttrennungskalibrierungsdaten für überzählige Schichten mit demselben reduzierten Flipwinkel bestimmt werden.

7. Verfahren nach einem der vorhergehenden Ansprüche, wobei bereits aufgenommene Schichttrennungskalibrierungsdaten für überzählige Schichten durch Multiplikation mit einem Faktor zwischen Null und Eins in ihrer Amplitude reduziert werden.

8. Verfahren nach Anspruch 7, wobei der Faktor von dem reduzierten Flipwinkel abhängt.

9. Verfahren nach einem der vorhergehenden Ansprüche, wobei die aus überzähligen Schichten aufgenommenen MR-Signale als Navigatordaten verwendet werden.

10. Verfahren nach einem der vorhergehenden Ansprüche, wobei die aufzunehmenden Schichten eine Schichtdicke von unter 3 Millimeter, bevorzugt unter 2 Millimeter, besonders bevorzugt etwa 1 Millimeter und/oder der zu messende Schichtstapel eine Dicke von unter 4 Zentimeter, bevorzugt unter 3 Zentimeter, besonders bevorzugt unter 2 Zentimeter haben.

11. Magnetresonanzanlage (1) umfassend eine Magneteinheit (3), eine Gradienteneinheit (5), eine Hochfrequenzeinheit (7) und eine Steuereinrichtung (9) mit einer Hochfrequenz-Sende-/Empfangs-Steuerung (7') und mit einer Wiederholzeitbestimmungseinheit (15), wobei die Steuereinrichtung (9) dazu ausgebildet ist, ein Verfahren nach einem der Ansprüche 1 bis 10 auf der Magnetresonanzanlage (1) auszuführen.

12. Computerprogramm, welches direkt in einen Speicher einer Steuereinrichtung (9) einer Magnetresonanzanlage (1) ladbar ist, mit Programm-Mitteln, um die Schritte des Verfahrens nach einem der Ansprüche 1 bis 10 auszuführen, wenn das Programm in der Steuereinrichtung (9) der Magnetresonanzanlage (1) ausgeführt wird.

13. Elektronisch lesbarer Datenträger mit darauf gespeicherten elektronisch lesbaren Steuerinformationen, welche zumindest ein Computerprogramm nach Anspruch 12 umfassen und derart ausgestaltet sind, dass sie bei Verwendung des Datenträgers in einer Steuereinrichtung (9) einer Magnetresonanzanlage (1) ein Verfahren nach einem der Ansprüche 1 bis 10 durchführen.

## Claims

1. Method for improved recording of scan data of an examination object by means of a magnetic resonance system with the aid of a simultaneous multi-slice (SMS) method using at least two receiving coils, wherein magnetic resonance (MR) signals are recorded in at least two slice groups of different slices of the examination object (U), wherein slices included by a slice group are recorded simultaneously during a recording of MR signals (MDᵢ), comprising the steps:
- loading a scan protocol with which the MR signals are to be recorded and which comprises a slice stack to be recorded, an SMS factor F to be used during the recording and at least one quality criterion,
- determining a minimum repetition time TR dependent upon the at least one quality criterion,
- calculating a number K of slices from which MR signals can be recorded with a number M of possible excitations and recordings of MR signals of a slice group within the determined minimum repetition time, said number M being determined on the basis of a slice group scan time specified by the scan protocol for exciting and recording MR signals of a slice group and of the determined minimum repetition time TR,
- determining multi-band RF pulses (MB₁...MB_{M}) for exciting M slice groups each comprising F slices which altogether comprise the slice stack to be recorded,
- recording MR signals (MDᵢ) using the multi-band RF pulses (MBᵢ) within the determined minimum repetition time,
- loading slice separation calibration data for the slice stack to be recorded,
- separating the MR signals (MDᵢ) of the slice groups respectively into single slice MR signals (MDᵢ₁...MD_{iF}) of the individual slices included by the slice groups making use of the slice separation calibration data,
- generating image data (BDᵢⱼ) of at least one slice included by the slice stack to be recorded, by reconstruction of the single slice MR signals (MDᵢ₁...MDᵢₖ) of the slice,
wherein, on the basis of the determined number K and on the basis of the scan protocol, a number of excess slices and their respective slice positions are determined, and
wherein, in the determination of the multi-band RF pulses (MB₁...MB_{M}) for excess slices, a reduced flip angle of approximately 33% of a corresponding non-reduced value of a flip angle to be used specified for non-excess slices, or less is specified.

2. Method according to claim 1, wherein the at least one quality criterion is a desired contrast and/or a desired image quality.

3. Method according to claim 1 or 2, wherein MR signals recorded from excess slices are discarded.

4. Method according to one of the preceding claims, wherein, in the determination of the multi-band RF pulses (MB₁...MB_{M}) for excess slices, a flip angle of zero is specified.

5. Method according to claim 4, wherein the slice separation calibration data for excess slices is occupied with the value zero or with values simulating noise.

6. Method according to one of the preceding claims, wherein slice separation calibration data for excess slices is determined with the same reduced flip angle.

7. Method according to one of the preceding claims, wherein already recorded slice separation calibration data for excess slices is reduced in its amplitude by multiplication by a factor of between zero and one.

8. Method according to claim 7, wherein the factor depends upon the reduced flip angle.

9. Method according to one of the preceding claims, wherein the MR signals recorded from excess slices are used as navigator data.

10. Method according to one of the preceding claims, wherein the slices to be recorded have a slice thickness of less than 3 millimetres, preferably less than 2 millimetres, particularly preferably approximately 1 millimetre and/or the slice stack to be scanned has a thickness of less than 4 centimetres, preferably less than 3 centimetres, particularly preferably less than 2 centimetres.

11. Magnetic resonance system (1), comprising a magnet unit (3), a gradient unit (5), a high frequency unit (7) and a control apparatus (9) with a high frequency transmitting/receiving control system (7') and a repetition time determining unit (15), wherein the control device (9) is configured to carry out a method according to one of claims 1 to 10 on the magnetic resonance system (1).

12. Computer program which is directly loadable into a memory store of a control apparatus (9) of a magnetic resonance system (1), having program means in order to carry out the steps of the method according to one of claims 1 to 10 when the program is executed in the control apparatus (9) of the magnetic resonance system (1).

13. Electronically readable data carrier with electronically readable control information stored thereon which comprises at least one computer program according to claim 12 and is configured such that, when the data carrier is used in a control apparatus (9) of a magnetic resonance system (1), said control information carries out a method according to one of claims 1 to 10.

## Revendications

1. Procédé d'enregistrement amélioré de données de mesure d'un objet en examen au moyen d'une installation par résonance magnétique à l'aide d'un procédé simultané à plusieurs couches (SMS) en utilisant au moins deux bobines de réception, dans lequel on enregistre des signaux de résonance magnétique (RM) dans au moins deux groupes de couches composés de couches différentes de l'objet (U) en examen, dans lequel on enregistre des couches comprises dans un groupe de couches simultanément lors d'un enregistrement de signaux RM (MDᵢ) comprenant les stades :
- chargement d'un protocole de mesure, par lequel les signaux RM doivent être enregistrés, qui comprend un empilement de couches à enregistrer, un facteur SMS F à utiliser à l'enregistrement et au moins un critère de qualité,
- détermination d'un temps TR de répétition minimum en fonction du au moins un critère de qualité,
- calcul d'un nombre K de couches à partir desquelles on peut avec, sur la base d'un temps de mesure de groupe de couches, donné à l'avance par le protocole de mesure, pour l'excitation et l'enregistrement de signaux RM d'un groupe de couches et du temps TR de répétition minimum déterminé, un nombre M déterminé d'excitation et d'enregistrement possible de signaux RM d'un groupe de couches, enregistrer des signaux RM dans le temps de répétition minimum déterminé,
- détermination d'impulsions (MB₁...MB_{M}) RF multibande pour l'excitation de M groupes de couches comprenant respectivement F couches, qui comprennent dans l'ensemble l'empilement de couches à enregistrer,
- enregistrement de signaux (MDᵢ) RM en utilisant les impulsions (MBᵢ) RF multibande dans le temps de répétition minimum déterminé,
- chargement de données d'étalonnage de séparation de couches pour l'empilement de couches à enregistrer,
- séparation des signaux (MDᵢ) RM des groupes de couches respectivement en des signaux (MDᵢ₁ ... MD_{iF}) RM de couche individuelle des couches individuelles comprises par des groupes de couches en utilisant des données d'étalonnage de séparation de couches,
- établissement de données (BDᵢⱼ) d'image d'au moins une couche comprise par l'empilement de couches à enregistrer par reconstruction des signaux (MDᵢ₁ ... MD_{iK}) RM de couche individuelle de la couche,
dans lequel sur la base du nombre K déterminé et sur la base du protocole de mesure, on détermine un nombre de couches en surnombre et leur position de couche respective, et
dans lequel, pour la détermination des impulsions (MB₁...MB_{M}) RF multibande pour des couches en surnombre, on prescrit un angle de flip réduit d'environ 33% d'une valeur non réduite correspondante donnée à l'avance pour des couches, qui ne sont pas en surnombre, d'un angle de flip à appliquer ou moins.

2. Procédé suivant la revendication 1, dans lequel le au moins un critère de qualité est un contraste souhaité et/ou une qualité d'image souhaitée.

3. Procédé suivant la revendication 1 ou 2, dans lequel on rejette des signaux RM enregistrés à partir de couches en surnombre.

4. Procédé suivant l'une des revendications précédentes, dans lequel, lors de la détermination des impulsions (MB₁...MB_{M}) RF multibande, on prescrit pour des couches en surnombre un angle de flip de zéro.

5. Procédé suivant la revendication 4, dans lequel on occupe les données d'étalonnage de séparation de couches pour des couches en surnombre par la valeur zéro ou par des valeurs simulant des bruits.

6. Procédé suivant l'une des revendications précédentes, dans lequel on détermine des données d'étalonnage de séparation de couches pour des couches en surnombre ayant le même angle de flip réduit.

7. Procédé suivant l'une des revendications précédentes, dans lequel on réduit dans leur amplitude, par multiplication par un facteur compris entre zéro et un, des données d'étalonnage de séparation de couches déjà enregistrées pour des couches en surnombre.

8. Procédé suivant la revendication 7, dans lequel le facteur dépend de l'angle de flip réduit.

9. Procédé suivant l'une des revendications précédentes, dans lequel on utilise comme données de navigateur les signaux RM enregistrés à partir de couches en surnombre.

10. Procédé suivant l'une des revendications précédentes, dans lequel les couches enregistrées ont une épaisseur de couche de moins de 3 millimètres, de préférence de moins de 2 millimètres, d'une manière particulièrement préférée d'environ 1 millimètre et/ou l'empilement de couches à mesurer a une épaisseur de moins de 4 centimètres, de préférence de moins de 3 centimètres, d'une manière particulièrement préférée de moins de 2 centimètres.

11. Installation (1) à résonance magnétique comprenant une unité (3) d'aimant, une unité (5) de gradient, une unité (7) de haute fréquence et un dispositif (9) de commande ayant une commande (7') d'émission/réception en haute fréquence et comprenant une unité (15) de détermination d'un temps de répétition, dans laquelle le dispositif (9) de commande est constitué pour exécuter un procédé suivant l'une des revendications 1 à 10 sur l'installation (1) à résonance magnétique.

12. Programme d'ordinateur, qui peut être chargé directement dans la mémoire d'un dispositif (9) de commande d'une installation (1) à résonance magnétique, comprenant des moyens de programme pour exécuter les stades du procédé suivant l'une des revendications 1 à 10, lorsque le programme est exécuté dans le dispositif (9) de commande de l'installation (1) à résonance magnétique.

13. Support de données déchiffrables électroniquement sur lequel sont mises en mémoire des informations de commande déchiffrables électroniquement, qui comprennent au moins un programme d'ordinateur suivant la revendication 12 et qui sont conformées de manière à ce qu'elles exécutent, lors de l'utilisation du support de données dans un dispositif (9) de commande d'une installation (1) à résonance magnétique, un procédé suivant l'une des revendications 1 à 10.
